# EUROPÄISCHE PATENTANMELDUNG

(11) **EP 4 258 345 A1**
(43) Veröffentlichungstag der Anmeldung: **11.10.2023**
(21) Anmeldenummer: 23155558.2
(22) Anmeldetag: 08.02.2023
(51) Int. Cl.: H01L 23/367, H01L 23/373, H01L 23/46

(54) **KÜHLKÖRPER, KÜHLVORRICHTUNG ZUR KÜHLUNG EINER ELEKTRONISCHEN VORRICHTUNG MIT DEM KÜHLKÖRPER UND HERSTELLUNGSVERFAHREN DER KÜHLVORRICHTUNG**

(30) Priorität: 05.04.2022 DE 102022108130
(71) Anmelder: Interplex NAS Electronics GmbH, 74078 Heilbronn (DE)
(72) Erfinder: Die Erfindernennung liegt noch nicht vor
(74) Vertreter: Staeger & Sperling Partnerschaftsgesellschaft mbB

(57) **Zusammenfassung**

Die Erfindung betrifft einen Kühlkörper (1) für eine Kühlvorrichtung (10) zur Kühlung einer elektronischen Vorrichtung mit einem Grundkörper (2) und einer Vielzahl von Vorsprüngen (3), welche von einer ersten Oberfläche (22) des Grundkörpers (2) hervorstehen,
wobei der Grundkörper (2) mittels eines Stapels (21) aus einer Vielzahl von alternierend angeordneten, vorzugsweise verschweißten, ersten Bandstreifen (4) und zweiten Bandstreifen (5) ausgebildet ist,
wobei an einer axialen Seitenfläche des jeweiligen ersten Bandstreifens (4) und/oder des jeweiligen zweiten Bandstreifens (5) zumindest ein Vorsprung (3) der Vielzahl von Vorsprüngen (3) derart ausgebildet ist, dass eine vorbestimmte Anordnung der Vielzahl von Vorsprüngen an der ersten Oberfläche (22) des Grundkörpers (2) ausgebildet ist.

Ferner betrifft die Erfindung eine Kühlvorrichtung (10) zur Kühlung einer elektronischen Vorrichtung mit dem Kühlkörper (1) und ein Herstellungsverfahren der Kühlvorrichtung (10) zur Kühlung einer elektronischen Vorrichtung mit dem Kühlkörper (1).

## Beschreibung

Die Erfindung betrifft einen Kühlkörper für eine Kühlvorrichtung zur Kühlung einer elektronischen Vorrichtung mit einem Grundkörper und einer Vielzahl von Vorsprüngen, welche von einer ersten Oberfläche des Grundkörpers hervorstehen. Ferner betrifft die Erfindung eine Kühlvorrichtung zur Kühlung einer elektronischen Vorrichtung mit dem Kühlkörper und ein Herstellungsverfahren der Kühlvorrichtung zur Kühlung einer elektronischen Vorrichtung mit dem Kühlkörper.

Kühlkörper werden an elektrischen und/oder elektronischen Vorrichtungen eingesetzt, um gezielt die von diesen erzeugte Verlustwärme abzuführen und auf dies Weise eine Schädigung durch Überhitzung zu verhindern. Beispielsweise bei Kraftfahrzeugen werden insbesondere Halbleiter und Leuchtmittel von LED-Scheinwerfern gekühlt. Hierbei ist meistens der zur Verfügung stehende Raum eng begrenzt, so dass jedes Bauteil mit dem Kühlkörper insgesamt eine kompakte Bauweise aufweisen muss.

In der DE 43 14 663 A1 ist beispielsweise ein Kühlkörper für Halbleiterbauelemente mit einer Grundplatte offenbart, auf der mit Abstand parallele Kühlrippen befestigt sind. Die Grundplatte weist an einer Oberfläche Haltenuten auf, in welchen jeweils eine Kühlrippe mit einem Sockelabschnitt festgelegt ist. In die Kühlrippen sind jeweils mehrere Durchbrüche eingeformt und die Flächen des zwischen zwei Stegen verlaufenden Durchbruches etwas geringer ist als der durch den lichten Rippenabstand vorgegebene Strömungsquerschnitt zwischen zwei benachbarten Kühlrippen. Das Festlegen der Rippen in der Grundplatte erfordert jedoch einen hohen Herstellungsaufwand.

Es ist daher Aufgabe der vorliegenden Erfindung, eine Kühlvorrichtung und einem Kühlkörper sowie ein entsprechendes Herstellungsverfahren bereitzustellen, bei welchem eine Kühlleistung optimiert und der Herstellungsaufwand reduziert ist.

Diese Aufgabe wird durch die Merkmalskombination gemäß Patentanspruch 1 gelöst.

Erfindungsgemäß wird ein Kühlkörper für eine Kühlvorrichtung zur Kühlung, vorzugsweise Fluidkühlung, einer elektronischen Vorrichtung, insbesondere eines Halbleiterbauelements, mit einem Grundkörper und einer Vielzahl von Vorsprüngen, welche von einer ersten Oberfläche des Grundkörpers hervorstehen, vorgeschlagen. Dabei ist der Grundkörper mittels eines Stapels aus einer Vielzahl von alternierend angeordneten, vorzugsweise verschweißten, ersten Bandstreifen und zweiten Bandstreifen ausgebildet. Ferner ist an einer axialen Seitenfläche des jeweiligen ersten Bandstreifens und/oder des jeweiligen zweiten Bandstreifens zumindest ein Vorsprung der Vielzahl von Vorsprüngen derart ausgebildet, dass eine vorbestimmte Anordnung der Vielzahl von Vorsprüngen an der ersten Oberfläche des Grundkörpers ausgebildet ist.

Vorteilhaft daran ist, dass der Kühlkörper mittels der vorbestimmten Anordnung der Vielzahl von Vorsprüngen an der ersten Oberfläche des Grundkörpers optimal an den jeweiligen Anwendungsfall anpassbar ist, wodurch die Kühlleistung des Kühlkörpers optimiert ist. Der Kühlkörper ist dabei für eine Fluidkühlung ausgelegt, insbesondere für eine Kühlung mittels Luft oder Wasser. Darüber hinaus sind jedoch auch andere Gase oder Flüssigkeiten als Kühlfluid denkbar.

In einer vorteilhaften Ausführungsvariante ist vorgesehen, dass an dem ersten Bandstreifen und dem zweiten Bandstreifen mehrere Vorsprünge der Vielzahl von Vorsprüngen gleichmäßig über die axiale Erstreckung des jeweiligen Bandstreifens verteilt angeordnet sind, insbesondere kammartig. Diese Anordnung ist besonders für eine verbesserte Kühlung geeignet.

Vorzugsweise ist der Kühlkörper derart ausgebildet, dass der erste Bandstreifen und der zweite Bandstreifen kongruent ausgebildet sind. In einem Ausführungsbeispiel der Erfindung ist vorgesehen, dass der jeweilige zweite Bandstreifen hinsichtlich des entsprechenden ersten Bandstreifens um 180° um eine zur ersten Oberfläche des Grundkörpers senkrechten Achse rotiert angeordnet ist. Dabei ist günstig, dass ein Ausbilden des Grundkörpers durch den Stapel aus der Vielzahl von alternierend angeordneten ersten Bandstreifen und zweiten Bandstreifen verbessert ist.

Ferner ist eine Ausführung günstig, bei welcher die Vielzahl von Vorsprüngen derart angeordnet ist, dass abwechselnd eine Reihe von Vorsprüngen der ersten Bandstreifen und eine Reihe von Vorsprüngen der zweiten Bandstreifen an der ersten Oberfläche des Grundkörpers ausgebildet ist. Vorteilhaft daran ist, dass eine Kühlleistung des Kühlkörpers durch die entsprechende Anordnung der Vorsprünge optimiert ist.

In einer weiteren vorteilhaften Variante ist erfindungsgemäß vorgesehen, dass zumindest ein Vorsprung ausgespart ist. Weiter vorteilhaft ist es, wenn ein erster und/oder ein letzter Vorsprung ausgespart ist. Auf diese Weise ist eine zusätzliche Variantenanzahl von vorbestimmten Anordnungen der Vielzahl von Vorsprüngen an der ersten Oberfläche des Grundkörpers umsetzbar.

Der erfindungsgemäße Kühlkörper ist in einer Ausführungsvariante ausgebildet, dass an einem oder beiden axialen Endabschnitt/en des jeweiligen ersten Bandstreifens und/oder des jeweiligen zweiten Bandstreifens eine Schweißkante ausgebildet ist. In einer vorteilhaften Ausführungsform des vorliegenden Kühlkörpers ist ferner vorgesehen, dass die Schweißkante eine Aussparung aufweist, derart, dass an dem Grundkörper eine Nut ausgebildet ist. Dabei ist günstig, dass der Stapel von aus der Vielzahl von alternierend angeordneten ersten Bandstreifen und zweiten Bandstreifen mittels Schweißen zur Ausbildung des Grundkörpers fixierbar ist. Alternativ sind jedoch auch weitere Befestigungsmöglichkeiten zwischen den jeweiligen ersten und zweiten Bandstreifen denkbar, wie beispielsweise ein Verkleben oder ein mechanisches Clinchen. Sofern dies der Fall ist, ist die Schweißkante entsprechend der gewählten Befestigungsmöglichkeit ausgebildet oder entfällt.

In einer bevorzugten Ausführungsform der Erfindung sind die Vorsprünge an dem ersten Bandstreifen und dem zweiten Bandstreifen einstückig ausgebildet. Dadurch ist eine Herstellung des Kühlkörpers vereinfacht, da lediglich die ersten und zweiten Bandstreifen zu stapeln sind, ohne dass nachträglich die Vorsprünge an dem Grundkörper fixiert werden müssen. Außerdem ist die Bauteilfestigkeit erhöht.

Darüber hinaus ist in einem vorteilhaften Ausführungsbeispiel der jeweilige erste Bandstreifen und der jeweilige zweite Bandstreifen ein Metallbandstreifen ist. Ein Metallbandstreifen ist besonders für einen Kühlkörper geeignet, da dieser eine hohe Wärmeleitfähigkeit besitzt und vorteilhaft hinsichtlich einer Verarbeitung bzw. einer Herstellung des Kühlkörpers ist.

Ferner ist eine Ausführung günstig, bei welcher der jeweilige Vorsprung stegförmig, pinförmig, bolzenförmig, stiftförmig, s-förmig oder dreieckförmig ausgebildet ist. Diese Varianten sind für einen jeweiligen Anwendungsfall des Kühlkörpers besonders geeignet und auf diese Weise ist der Kühlkörper an den jeweiligen Anwendungsfall anpassbar und optimierbar.

In einer weiteren vorteilhaften Variante ist erfindungsgemäß vorgesehen, dass der Stapel aus der Vielzahl von alternierend angeordneten ersten Bandstreifen und zweiten Bandstreifen in einem Magazin angeordnet/fixiert ist. Dadurch ist eine Anwendung des Kühlkörpers bzw. ein Weiterverarbeiten des Kühlkörpers, beispielsweise ein Anordnen in einer Kühlvorrichtung, optimiert.

Außerdem wird erfindungsgemäß eine Kühlvorrichtung zur Kühlung einer elektronischen Vorrichtung mit einem Kühlkörper gemäß der vorstehenden Offenbarung vorgeschlagen. Dabei ist der Kühlkörper mit einer der ersten Oberfläche gegenüberliegenden zweiten Oberfläche des Grundkörpers auf einer Basisplatte, vorzugsweise aus Kupfer oder Aluminium, fixiert und der Kühlkörper in einem Gehäuse, welches an der Basisplatte fixiert ist, aufgenommen. Darüber hinaus weist das Gehäuse vorzugsweise einen Einlass und einen Auslass für ein Fluid auf. Insbesondere umfasst die Basisplatte ferner eine Beschichtung, welche abhängig von der Fixierung des Kühlkörpers auf der Basisplatte wählbar ist. Der Kühlkörper ist beispielsweise mittels Kleben oder Löten, insbesondere Hartlöten, Reflow-Löten oder Wiederaufschmelzlöten, auf der Basisplatte fixiert. In einer besonders günstigen Ausführungsvariante, bei welcher der Kühlkörper mittels Reflow-Löten auf der Basisplatte fixiert ist, umfasst die Basisplatte aus Kupfer eine Nickel-Zinn-Beschichtung (Ni-Sn).

Dabei ist günstig, dass die Kühlvorrichtung mittels des erfindungsgemäßen Kühlkörpers und der entsprechenden vorbestimmten Anordnung der Vielzahl von Vorsprüngen an der ersten Oberfläche des Grundkörpers optimal an den jeweiligen Anwendungsfall anpassbar ist, wodurch die Kühlleistung der Kühlvorrichtung optimiert ist.

Erfindungsgemäß wird ferner ein Herstellungsverfahren einer Kühlvorrichtung zur Kühlung einer elektronischen Vorrichtung mit einem Kühlkörper gemäß der vorstehenden Offenbarung vorgeschlagen. Dabei erfolgt zunächst ein Stanzen eines Bands, insbesondere eines kontinuierlichen oder diskontinuierlichen Metallbands, mittels einer Stanzvorrichtung, wobei jeweils ein erster Bandstreifen und ein zweiter Bandstreifen und die Vielzahl von Vorsprüngen in einem gemeinsamen Abschnitt des Bands ausgebildet werden. Anschließend wird der Grundkörper durch alternierendes Stapeln jeweils eines ersten Bandstreifens und eines zweiten Bandstreifens derart ausgebildet, dass die Vielzahl von Vorsprüngen entsprechend der vorbestimmten Anordnung von der ersten Oberfläche des Grundkörpers hervorstehen und durch Fixieren der ersten und zweiten Bandstreifen, insbesondere Verschweißen, weiter insbesondere Laserschweißen, des Stapels. Daraufhin erfolgt ein Fixieren des Kühlkörpers mit der zweiten Oberfläche des Grundkörpers auf einer Basisplatte, vorzugsweise mittels Reflow-Löten oder Wiederaufschmelzlöten und einer Lötpaste. Danach wir das Gehäuse an der Basisplatte fixiert, vorzugsweise verklebt, wobei der Kühlkörper in dem Gehäuse aufgenommen ist.

Vorteilhaft daran ist, dass eine Kühlvorrichtung und dabei auch ein erfindungsgemäßer Kühlkörper hergestellt wird, welche mittels des Kühlkörpers und der entsprechenden vorbestimmten Anordnung der Vielzahl von Vorsprüngen an der ersten Oberfläche des Grundkörpers optimal an den jeweiligen Anwendungsfall angepasst wird, wodurch die Kühlleistung der Kühlvorrichtung optimiert wird.

In einer vorteilhaften Ausführungsvariante ist vorgesehen, dass zumindest ein Vorsprung des ersten und/oder zweiten Bandstreifens ausgespart wird, vorzugsweise in einem Bereich in dem das Band getrennt wird. Ferner ist eine Ausführung günstig, bei welcher das Band nach einer vorbestimmten Länge beim Stanzen getrennt wird. Dadurch wird die Herstellung der ersten und zweiten Bandstreifen verbessert. Außerdem kann auf diese Weise während dem Stanzen des Bandes gleichzeitig auch die Schweißkannte ausgebildet werden. Ferner kann eine zusätzliche Variantenanzahl von vorbestimmten Anordnungen der Vielzahl von Vorsprüngen an der ersten Oberfläche des Grundkörpers umgesetzt werden.

In einer bevorzugten Ausführungsform des Verfahrens werden der jeweilige erste und zweite Bandstreifen beim Stanzen kongruent ausgebildet. Außerdem wird das erfindungsgemäße Verfahren in einer Ausführungsvariante derart durchgeführt, dass beim Ausbilden des Grundkörpers der jeweilige zweite Bandstreifen hinsichtlich des entsprechenden ersten Bandstreifens um 180° um eine zur ersten Oberfläche des Grundkörpers senkrechten Achse rotiert angeordnet ist. Dabei ist günstig, dass das Ausbilden des Grundkörpers durch den Stapel aus der Vielzahl von alternierend angeordneten ersten Bandstreifen und zweiten Bandstreifen verbessert ist.

In einer weiteren vorteilhaften Variante ist erfindungsgemäß vorgesehen, dass eine Fördervorrichtung vorgesehen ist, welche ausgebildet ist das Band innerhalb einer Produktionslinie zu fördern. Dabei ist das Band während des Stanzens an der Fördervorrichtung angeordnet und wird insbesondere kontinuierlich von der Fördervorrichtung gefördert, insbesondere zu der Stanzvorrichtung. In einem Ausführungsbeispiel des Verfahrens ist vorgesehen, dass das Band wenigstens einen Pilotstreifen umfasst, der jeweils auf einer oder auf beiden Längsseiten des Bands vorgesehen ist, und die Fördervorrichtung das Band mittels des Pilotstreifens fördert. Dadurch ist die Förderung des Bandes umgesetzt.

Die vorstehend offenbarten Merkmale sind beliebig kombinierbar, soweit dies technisch möglich ist und diese nicht im Widerspruch zueinander stehen.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:
- Fig. 1: eine perspektivische Ansicht eines Kühlkörpers;
- Fig. 2: eine Explosionsansicht einer Kühlvorrichtung mit dem Kühlkörper;
- Fig. 3: eine perspektivische Ansicht von Komponenten des Kühlkörpersbei der Herstellung

Die Figuren sind beispielhaft schematisch. Gleiche Bezugszeichen in den Figuren weisen auf gleiche funktionale und/oder strukturelle Merkmale hin.

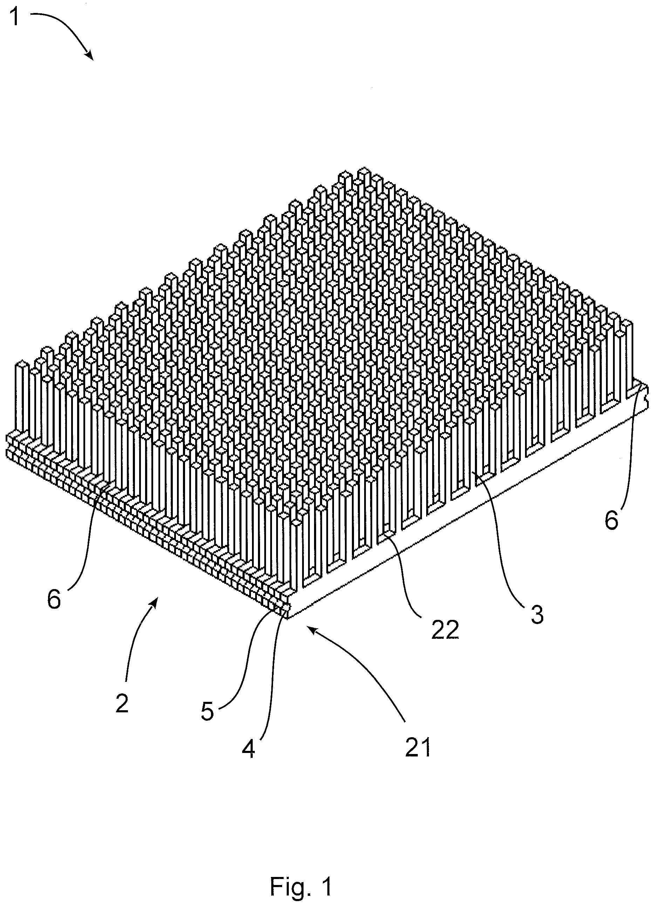

In Figur 1 ist eine perspektivische Ansicht eines Kühlkörpers 1 für eine Kühlvorrichtung 10 zur Fluidkühlung einer elektronischen Vorrichtung mit einem Grundkörper 2 und einer Vielzahl von Vorsprüngen 3, welche von einer ersten Oberfläche 22 des Grundkörpers 2 hervorstehen dargestellt. Der Grundkörper 2 ist mittels eines Stapels 21 aus einer Vielzahl von alternierend angeordneten und verschweißten, ersten Bandstreifen 4 und zweiten Bandstreifen 5 ausgebildet. Der jeweilige erste Bandstreifen 4 und der jeweilige zweite Bandstreifen 5 ist ein Metallbandstreifen. An einer axialen Seitenfläche des jeweiligen ersten Bandstreifens 4 und des jeweiligen zweiten Bandstreifens 5 sind jeweils 14 Vorsprünge 3 der Vielzahl von Vorsprüngen 3 derart ausgebildet ist, dass eine vorbestimmte Anordnung der Vielzahl von Vorsprüngen 3 an der ersten Oberfläche 22 des Grundkörpers 2 ausgebildet ist. Dabei sind die entsprechenden Vorsprünge 3 gleichmäßig über die axiale Erstreckung des jeweiligen Bandstreifens 4, 5 verteilt angeordnet, insbesondere kammartig, und die Vorsprünge sind an dem ersten Bandstreifen und dem zweiten Bandstreifen einstückig ausgebildet. Ferner sind der erste Bandstreifen 4 und der zweite Bandstreifen 5 kongruent ausgebildet. Des Weiteren ist der jeweilige zweite Bandstreifen 5 hinsichtlich des entsprechenden ersten Bandstreifens 4 um 180° um eine zur ersten Oberfläche 22 des Grundkörpers 2 senkrechten Achse rotiert angeordnet.

Außerdem ist die vorbestimmte Anordnung der Vielzahl von Vorsprüngen 3 an der ersten Oberfläche 22 des Grundkörpers 2 derart ausgebildet, dass abwechselnd eine Reihe von Vorsprüngen 3 der ersten Bandstreifen 4 und eine Reihe von Vorsprüngen 3 der zweiten Bandstreifen 5 an der ersten Oberfläche 22 des Grundkörpers 2 angeordnet ist. Dabei ist jeweils der erste und der letzte Vorsprung 3 des jeweiligen Bandstreifens 4, 5 ausgespart. Ferner ist der jeweilige Vorsprung 3 stegförmig ausgebildet.

Darüber hinaus ist an beiden axialen Endabschnitten des jeweiligen ersten Bandstreifens 4 und des jeweiligen zweiten Bandstreifens 5 eine Schweißkante 6 ausgebildet. Die Schweißkante 6 weist dabei eine Aussparung auf, derart, dass an dem Grundkörper 2 eine Nut ausgebildet ist.

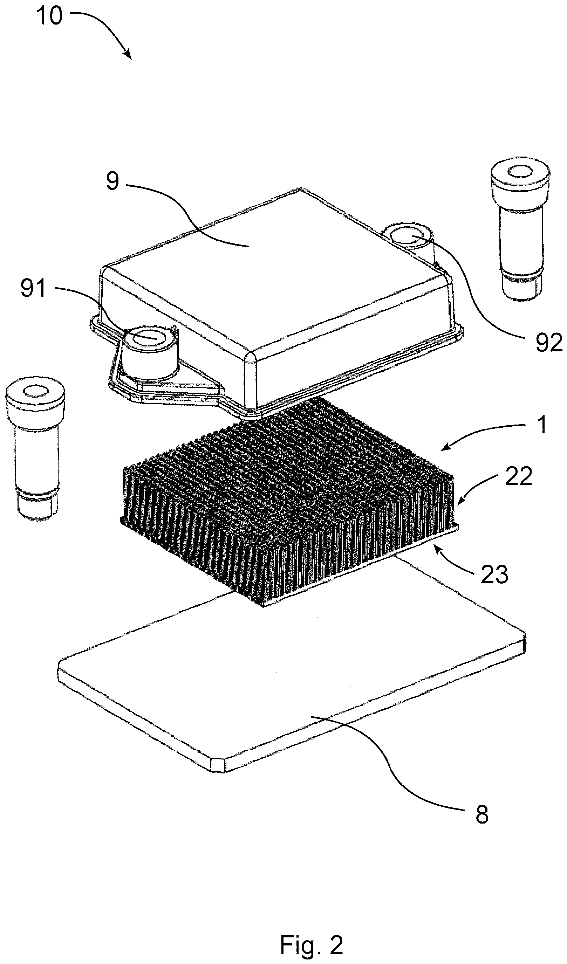

Figur 2 zeigt eine Explosionsansicht einer Kühlvorrichtung 10 zur Kühlung einer elektronischen Vorrichtung mit dem in Figur 1 dargestellten Kühlkörper 1. Der Kühlkörper 1 ist dabei mit einer der ersten Oberfläche 22 gegenüberliegenden zweiten Oberfläche 23 des Grundkörpers 2 auf einer Basisplatte 8 aus Kupfer, welche eine Nickel-Zinn-Beschichtung umfasst, fixiert und in einem Gehäuse 9, welches an der Basisplatte 8 befestigt ist, aufgenommen.

Dabei ist der Kühlkörper mit der zweiten Oberfläche 23 des Grundkörpers 2 auf der Basisplatte 8 mittels Reflow-Löten und einer Lötpaste fixiert. Außerdem weist das Gehäuse 9 einen Einlass 91 und einen Auslass 92 für ein Fluid auf.

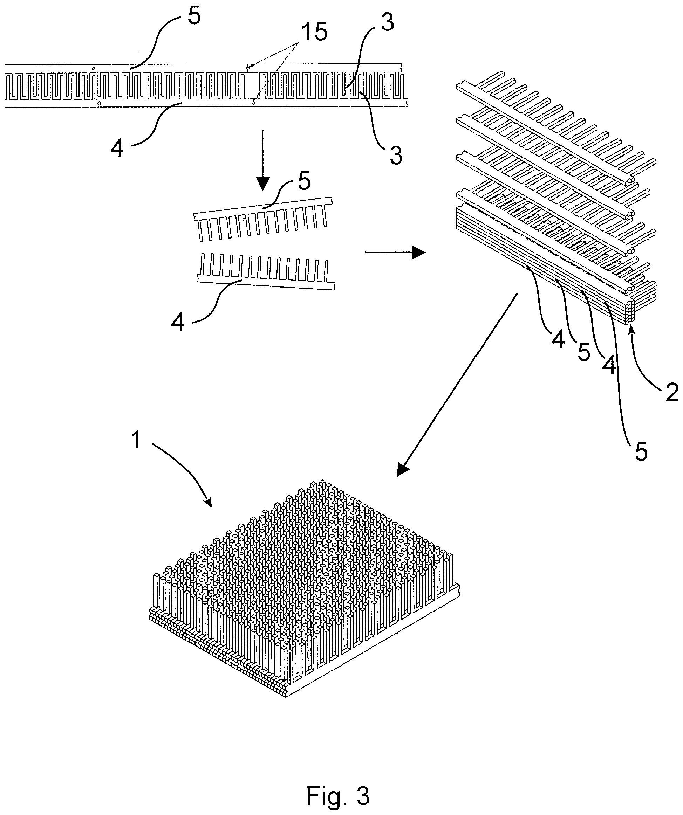

In Figur 3 ist eine perspektivische Ansicht von Komponenten des Kühlkörpers 1 bei der Herstellung dargestellt. Zunächst ist ein kontinuierliches Metallband nach dem Stanzen mittels einer Stanzvorrichtung dargestellt. Dabei ist jeweils ein erster Bandstreifen 4 und ein zweiter Bandstreifen 5 sowie die Vielzahl von Vorsprüngen 3 in einem gemeinsamen Abschnitt des Bands 10 ausgebildet. Ferner ist der Grundkörper 2 des Kühlkörpers 1 beim Stapeln dargestellt, welcher durch alternierendes Stapeln jeweils eines ersten Bandstreifens 4 und eines zweiten Bandstreifens 5 derart ausgebildet ist, dass die Vielzahl von Vorsprüngen 3 entsprechend der vorbestimmten Anordnung von der ersten Oberfläche 22 des Grundkörpers 2 hervorstehen. Außerdem sind die ersten und zweiten Bandstreifen 4, 5 des Stapels 21 durch Laserschweißen untereinander fixiert.

Darüber hinaus ist jeweils ein Vorsprung 3 des ersten und zweiten Bandstreifens 4, 5 in einem Bereich 15 in dem das Band nach einer vorbestimmten Länge beim Stanzen getrennt wird ausgespart. Der jeweilige erste und zweite Bandstreifen 4, 5 sind kongruent ausgebildet und beim Ausbilden des Grundkörpers 2 ist der jeweilige zweite Bandstreifen 5 hinsichtlich des entsprechenden ersten Bandstreifens 4 um 180° um eine zur ersten Oberfläche 22 des Grundkörpers 2 senkrechten Achse rotiert angeordnet ist.

Ferner umfasst das Band wenigstens einen Pilotstreifen, der jeweils auf beiden Längsseiten des Bands vorgesehen ist. Dadurch ist das Band mittels des Pilotstreifens von einer Fördervorrichtung förderbar. Der Pilotstreifen umfass dabei Pilotlöcher für die Förderung und das Band ist vorzugsweise im Bereich des Pilotlochs oder genau an dem Pilotloch von der Stanzvorrichtung getrennt.

Die Erfindung beschränkt sich in ihrer Ausführung nicht auf die vorstehend angegebenen bevorzugten Ausführungsbeispiele. Vielmehr ist eine Anzahl von Varianten denkbar, welche von der dargestellten Lösung auch bei grundsätzlich anders gearteten Ausführungen Gebrauch macht.

## Patentansprüche

1. Kühlkörper (1) für eine Kühlvorrichtung (10) zur Kühlung einer elektronischen Vorrichtung mit einem Grundkörper (2) und einer Vielzahl von Vorsprüngen (3), welche von einer ersten Oberfläche (22) des Grundkörpers (2) hervorstehen,
wobei der Grundkörper (2) mittels eines Stapels (21) aus einer Vielzahl von alternierend angeordneten, vorzugsweise verschweißten, ersten Bandstreifen (4) und zweiten Bandstreifen (5) ausgebildet ist,
wobei an einer axialen Seitenfläche des jeweiligen ersten Bandstreifens (4) und/oder des jeweiligen zweiten Bandstreifens (5) zumindest ein Vorsprung (3) der Vielzahl von Vorsprüngen (3) derart ausgebildet ist, dass eine vorbestimmte Anordnung der Vielzahl von Vorsprüngen an der ersten Oberfläche (22) des Grundkörpers (2) ausgebildet ist.

2. Kühlkörper (1) gemäß Anspruch 1, wobei an dem ersten Bandstreifen (4) und dem zweiten Bandstreifen (5) mehrere Vorsprünge (3) der Vielzahl von Vorsprüngen (3) gleichmäßig über die axiale Erstreckung des jeweiligen Bandstreifens (4, 5) verteilt angeordnet sind, insbesondere kammartig.

3. Kühlkörper (1) gemäß Anspruch 1 oder 2, wobei der erste Bandstreifen (4) und der zweite Bandstreifen (5) kongruent ausgebildet sind.

4. Kühlkörper (1) gemäß einem der Ansprüche 1 bis 3, wobei der jeweilige zweite Bandstreifen (5) hinsichtlich des entsprechenden ersten Bandstreifens (4) um 180° um eine zur ersten Oberfläche (22) des Grundkörpers (2) senkrechten Achse rotiert angeordnet ist.

5. Kühlkörper (1) gemäß einem der vorhergehenden Ansprüche, wobei die Vielzahl von Vorsprüngen (3) derart angeordnet ist, dass abwechselnd eine Reihe von Vorsprüngen (3) der ersten Bandstreifen (4) und eine Reihe von Vorsprüngen (3) der zweiten Bandstreifen (5) an der ersten Oberfläche (22) des Grundkörpers (2) ausgebildet ist.

6. Kühlkörper (1) gemäß einem der vorhergehenden Ansprüche, wobei zumindest ein Vorsprung (3) ausgespart ist.

7. Kühlkörper (1) gemäß einem der vorhergehenden Ansprüche, wobei an einem oder beiden axialen Endabschnitt/en des jeweiligen ersten Bandstreifens (4) und/oder des jeweiligen zweiten Bandstreifens (5) eine Schweißkante (6) ausgebildet ist.

8. Kühlkörper (1) gemäß dem vorhergehenden Anspruch, wobei die Schweißkante (6) eine Aussparung aufweist, derart, dass an dem Grundkörper (2) eine Nut ausgebildet ist.

9. Kühlkörper (1) gemäß einem der vorhergehenden Ansprüche, wobei sind die Vorsprünge (3) an dem ersten Bandstreifen (4) und dem zweiten Bandstreifen (5) einstückig ausgebildet sind und/oder insbesondere der jeweilige erste Bandstreifen (4) und der jeweilige zweite Bandstreifen (5) ein Metallbandstreifen ist.

10. Kühlkörper (1) gemäß einem der vorhergehenden Ansprüche, wobei der jeweilige Vorsprung (3) stegförmig, pinförmig, bolzenförmig, stiftförmig, s-förmig oder dreieckförmig ausgebildet ist.

11. Kühlkörper (1) gemäß einem der vorhergehenden Ansprüche, wobei der Stapel (21) aus der Vielzahl von alternierend angeordneten ersten Bandstreifen (4) und zweiten Bandstreifen (5) in einem Magazin (7) angeordnet/fixiert ist.

12. Kühlvorrichtung (10) zur Kühlung einer elektronischen Vorrichtung mit einem Kühlkörper (1) gemäß einem der vorhergehenden Ansprüche, wobei der Kühlkörper (1) mit einer der ersten Oberfläche (22) gegenüberliegenden zweiten Oberfläche (23) des Grundkörpers (2) auf einer Basisplatte (8), vorzugsweise aus Nickel, fixiert ist und der Kühlkörper (1) in einem Gehäuse (9), welches an der Basisplatte fixiert ist, aufgenommen ist, wobei das Gehäuse (9) vorzugsweise einen Einlass (91) und einen Auslass (92) für ein Fluid aufweist.

13. Herstellungsverfahren einer Kühlvorrichtung (10) zur Kühlung einer elektronischen Vorrichtung mit einem Kühlkörper (1) gemäß einem der vorhergehenden Ansprüche, welches die Schritte umfasst:
a. Stanzen eines Bands, insbesondere eines kontinuierlichen oder diskontinuierlichen Metallbands, mittels einer Stanzvorrichtung (13), wobei jeweils ein erster Bandstreifen (4) und ein zweiter Bandstreifen (5) sowie die Vielzahl von Vorsprüngen (3) in einem gemeinsamen Abschnitt des Bands ausgebildet werden,
b. Ausbilden des Grundkörpers (2) durch alternierendes Stapeln jeweils eines ersten Bandstreifens (4) und eines zweiten Bandstreifens (5) derart, dass die Vielzahl von Vorsprüngen (3) entsprechend der vorbestimmten Anordnung von der ersten Oberfläche (22) des Grundkörpers (2) hervorstehen, und durch Fixieren der ersten und zweiten Bandstreifen (4, 5), insbesondere Verschweißen, weiter insbesondere Laserschweißen, des Stapels (21).
c. Fixieren des Kühlkörpers (1) mit der zweiten Oberfläche (23) des Grundkörpers (2) auf einer Basisplatte (8), vorzugsweise mittels Reflow-Löten oder Wiederaufschmelzlöten und einer Lötpaste,
d. Fixieren des Gehäuses (9) an der Basisplatte (8), vorzugsweise verkleben, wobei der Kühlkörper (1) in dem Gehäuse (9) aufgenommen ist.

14. Herstellungsverfahren gemäß Anspruch 13, wobei beim Stanzen zumindest ein Vorsprung (3) des ersten und/oder zweiten Bandstreifens (4, 5) ausgespart wird, vorzugsweise in einem Bereich in dem das Band getrennt wird.

15. Herstellungsverfahren gemäß einem der Ansprüche 13 oder 14, wobei beim Ausbilden des Grundkörpers (2) der jeweilige zweite Bandstreifen (5) hinsichtlich des entsprechenden ersten Bandstreifens (4) um 180° um eine zur ersten Oberfläche (22) des Grundkörpers (2) senkrechten Achse rotiert angeordnet wird.
